# EUROPEAN PATENT APPLICATION

(11) **EP 1 681 372 A1**
(43) Date of publication of application: **19.07.2006**
(21) Application number: 04773428.0
(22) Date of filing: 17.09.2004
(51) Int. Cl.: C23C 18/40, C23C 18/31

(54) **ELECTROLESS COPPER PLATING SOLUTION AND METHOD FOR ELECTROLESS COPPER PLATING**

(30) Priority: 17.10.2003 JP 2003357993
(71) Applicant: Nikko Materials Company, Limited, Tokyo 105-0001 (JP)
(72) Inventor: YABE, Atsushi; c/o Isohara Plant, Nikko Materials, Kitaibaraki-shi, Ibaraki;3191535 (JP); SEKIGUCHI, Junnosuke; c/o Isohara Plant, Nikko, Kitaibaraki-shi, Ibaraki;3191535 (JP); IMORI, Toru; c/o Isohara Plant, Nikko Materials, Kitaibaraki- shi, Ibaraki;3191535 (JP); FUJIHIRA, Yoshihisa; c/o Takatsuki Plant, Nikko, Takatsuki-shi, Osaka;5690036 (JP)
(74) Representative: Gassenhuber, Andreas
(86) International application number: PCT/JP2004/014049
(87) International publication number: WO 2005/038087

(57) **Abstract**

An object is to provide an electroless copper plating solution that realizes uniform plating at lower temperatures, when the electroless copper plating is performed on a semiconductor wafer or other such mirror surface on which a plating reaction hardly occurs. An electroless copper plating solution, wherein, along with a first reducing agent, hypophosphorous acid or a hypophosphite is used as a second reducing agent, and a stabilizer to inhibit copper deposition is further used at the same time. Examples of the first reducing agent include formalin and glyoxylic acid, while examples of the hypophosphite include sodium hypophosphite, potassium hypophosphite, and ammonium hypophosphite. Examples of the stabilizer to inhibit copper deposition include 2,2'-bipyridyl, imidazole, nicotinic acid, thiourea, 2-mercaptobenzothiazole, sodium cyanide, and thioglycolic acid.

## Description

### TECHNICAL FIELD

This invention relates to an electroless copper plating solution used primarily in the electroless copper plating of a mirror surface such as a semiconductor wafer, and to an electroless copper plating method that makes use of this plating solution.

### BACKGROUND ART

Electroless copper plating holds great promise as a method to form a copper film for ULSI fine wiring, and as a replacement for the sputtering and electrolytic copper plating methods currently in use.

Conventionally, when a semiconductor wafer or other such mirror surface was electroless plated with copper, the plating reactivity was low and it was difficult to plate uniformly over the entire substrate. Examples of problems currently encountered in electroless copper plating include low adhesive strength and poor plating uniformity when a copper film is formed over a barrier metal layer such as tantalum nitride.

Formalin is typically used as a reducing agent for an electroless copper plating solution. But, because formalin is harmful to humans and the environment, glyoxylic acid, which shows a similar reaction mechanism, has been studied in recent years as a possible alternative. An electroless copper plating solution in which glyoxylic acid is used as a reducing agent was disclosed in Japanese Patent Publication No. 2002-249879.

Also, Japanese Patent Publication No. S57-501922 discloses an electroless copper plating solution that makes use of a second reducing agent along with a first reducing agent (formalin) as reducing agents of the electroless copper plating solution. This electroless copper plating solution is stable and has a high copper deposition speed, but it is difficult to plate uniformly when this solution was used on a semiconductor wafer or other such mirror surface.

### DISCLOSURE OF THE INVENTION

It is an object of the present invention to provide an electroless copper plating solution with which uniform plating at lower temperatures is realized, for a mirror surface such as a semiconductor wafer, on which a plating reaction is difficult to occur.

As a result of diligent study, the inventors discovered that when a first reducing agent (such as formalin or glyoxylic acid) and hypophosphorous acid or a hypophosphite (such as sodium hypophosphite, potassium hypophosphite, or ammonium hypophosphite) are used at the same time in an electroless copper plating solution, the initial plating reactivity via a metal catalyst is higher, and that when a stabilizer to inhibit copper deposition (such as 2,2'-bipyridyl, imidazole, nicotinic acid, thiourea, 2-mercaptobenzothiazole, sodium cyanide, or thioglycolic acid) is also used at the same time, excessive deposition reactions generated in some portion will be prevented, and as a result, uniform plating can be achieved at lower temperatures even on a semiconductor wafer (such as a silicon wafer, a semiconductor wafer made of GaAs·InP or the like, or these wafers with a tantalum nitride film, titanium nitride film, tungsten nitride film, tantalum film or the like formed thereon) or other such mirror surface with an average surface roughness of less than 10 nm. The present invention is particularly effective in the production of thin films with a thickness of 500 nm or less.

Specifically, the present invention is as follows.
(1) An electroless copper plating solution, wherein, along with a first reducing agent, hypophosphorous acid or a hypophosphite is used as a second reducing agent, and a stabilizer to inhibit copper deposition is further used at the same time.
(2) An electroless copper plating solution according to (1) above, which is used to produce a thin film with a thickness of 500 nm or less.
(3) An electroless copper plating method, wherein an electroless copper plating solution according to (1) or (2) above is used to perform electroless copper plating on a mirror surface whose average surface roughness is less than 10 nm.

### BEST MODE FOR CARRYING OUT THE INVENTION

Electroless copper plating solutions usually contain copper ions, copper ion complexing agents, reducing agents, pH regulators, and so forth. Formalin, glyoxylic acid or the like is typically used as a reducing agent for electroless copper plating solutions, meanwhile, in the present invention hypophosphorous acid or a hypophosphite is used as a second reducing agent along with these first reducing agents. Examples of the hypophosphites include sodium hypophosphite, potassium hypophosphite, and ammonium hypophosphite.

A stabilizer to inhibit copper deposition is further used in the present invention. Examples of the stabilizers to inhibit copper deposition include 2,2'-bipyridyl, imidazole, nicotinic acid, thiourea, 2-mercaptobenzothiazole, sodium cyanide, and thioglycolic acid.

The electroless copper plating solution of the present invention is extremely effective when used in performing uniform thin-film plating on a mirror surface with an average surface roughness of less than 10 nm. Examples of such mirror surfaces include a silicon wafer, a semiconductor wafer made of GaAs-InP or the like, and these wafers with a tantalum nitride film, titanium nitride film, tungsten nitride film, tantalum film or the like formed thereon.

The electroless copper plating solution of the present invention makes use of hypophosphorous acid or a hypophosphite as a second reducing agent along with a first reducing agent at the same time, which raises the plating reactivity higher than that when a first reducing agent is used alone, and as a result, uniform plating is achieved on a mirror surface such as a semiconductor wafer, on which a plating reaction hardly occur, at lower temperatures. While hypophosphorous acid and hypophosphites do not exhibit a reductive action on copper, they exhibit a highly reductive action on a catalyst metal such as palladium, so they are effective at raising the initial plating reactivity via a catalyst metal. By the enhance of plating reactivity, plating at a lower temperature is realized. The further use of the stabilizer to inhibit copper deposition increases solution stability and inhibits the excessive deposition reactions that occur in some parts, and as a result, the particles of deposited copper tend to be finer and more uniform. Since deposition uniformity at the start of plating is higher when the plating solution of the invention is used, a uniform thin film with a thickness of 500 nm or less can be formed on a mirror surface whose average surface roughness is less than 10 nm such as a semiconductor wafer.

The concentration of the first reducing agent in the plating solution is preferably from 0.005 to 0.5 mol/L, and even more preferably from 0.01 to 0.2 mol/L. No plating reaction will occur if the concentration is less than 0.005 mol/L, but the plating solution will be unstable and decompose if 0.5 mol/L is exceeded.

The concentration of hypophosphorous acid or hypophosphite in the plating solution is preferably from 0.001 to 0.5 mol/L, and even more preferably from 0.005 to 0.2 mol/L. The above-mentioned effect will not be seen if the concentration of hypophosphorous acid or hypophosphite is below 0.001 mol/L, but the plating solution will be unstable and decompose if 0.5 mol/L is exceeded.

The concentration of stabilizer to inhibit copper deposition in the plating solution is preferably from 0.1 to 500 mg/L, and even more preferably from 1 to 100 mg/L. The inhibitory effect will not be seen if the concentration is below 0.1 mg/L, but if 500 mg/L is exceeded, the plating will not be deposited due to the strong inhibitory effects.

Any copper ion source commonly used can be employed as the copper ion source in the electroless copper plating solution of the invention, examples of which include copper sulfate, copper chloride and copper nitrate.

Any complexing agents commonly used can be used as a copper ion complexing agent, examples of which include ethylenediaminetetraacetic acid, tartaric acid or the like.

As other additives, any additives commonly used in plating solutions such as polyethylene glycol or potassium ferrocyanide can be used.

The electroless copper plating solution of the present invention is preferably used at a pH of from 10 to 14, and even more preferably a pH of from 12 to 13. Sodium hydroxide, potassium hydroxide, or any other commonly used compounds can be used as a pH regulator.

From the standpoint of bath stability and copper deposition speed, the copper plating solution of the present invention is preferably used at a bath temperature of 55 to 75°C.

The followings, although not intended to be limiting, are favorable methods to fix a catalyst for electroless copper plating: the method disclosed in International Patent Publication No. WO01/49898, in which a pretreatment agent is prepared by reacting or mixing in advance a noble metal compound and a silane coupling agent having a functional group with metal capturing capability, and the surface of the material to be plated is treated with this pretreatment agent; the method disclosed in International Patent Publication No. WO03/091476, in which the surface to be plated is coated with a solution of a silane coupling agent having a functional group with metal capturing capability, and this surface is then coated with an organic solvent solution of a palladium compound; the method disclosed in Japanese Patent Application No. 2003-163105, in which the article to be plated is surface treated with a silane coupling agent having a functional group with metal capturing capability in one molecule, the article is heat treated at a high temperature of at least 150°C, and the article is surface treated with a solution containing a noble metal; and a method in which the article to be plated is surface treated with a solution obtained by reacting or mixing in advance a noble metal compound and a silane coupling agent having a functional group with metal capturing capability in one molecule, and the article is heat treated at a high temperature of at least 150°C.

The above-mentioned silane coupling agent having metal capturing capability is preferably one obtained by a reaction of an epoxy compound and, an azole compound or an amine compound.

Examples of the azole compound include imidazole, oxazole, thiazole, selenazole, pyrazole, isoxazole, isothiazole, triazole, oxadiazole, thiadiazole, tetrazole, oxatriazole, thiatriazole, bendazole, indazole, benzimidazole, and benzotriazole. Although this list is not intended to be a restriction, imidazole is particularly preferred.

Examples of the amine compound include saturated hydrocarbon amines such as propylamine, unsaturated hydrocarbon amines such as vinylamine, and aromatic amines such as phenylamine.

The above-mentioned silane coupling agent refers to a compound that has an -SiX₁X₂X₃ group in addition to the noble metal capturing group, which originates the above-mentioned azole compound or amine compound. X₁, X₂, and X₃ are each an alkyl group, halogen, alkoxy group or the like, and may be any functional groups that can be fixed to the article being plated. X₁, X₂, and X₃ may be the same or different.

The silane coupling agent can be obtained by reacting an epoxysilane compound with the above-mentioned azole compound or amine compound.
This epoxysilane compound is preferably an epoxy coupling agent expressed by the formula: 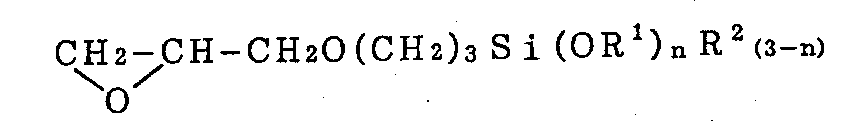 (where R¹ and R² are each a hydrogen or an alkyl group whose carbon number is 1 to 3, and n is a number from 0 to 3).

The reaction of the azole compound and the epoxy group-containing silane compound can be conducted, for example under the conditions discussed in Japanese Patent Publication No. H6-256358.
For example, the product can be obtained by adding a 0.1 to 10 mol of epoxy group-containing silane compound dropwise to a 1 mol of azole compound at 80 to 200°C and reacting for from 5 minutes to 2 hours. There is no particular need to use a solvent here, but chloroform, dioxane, methanol, ethanol or another such organic solvent may be used.

The following is a particularly favorable example of the reaction between imidazole compound and epoxysilane compound. 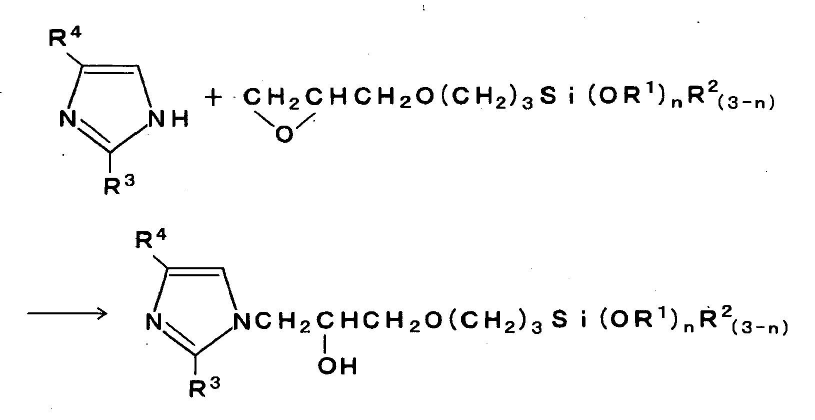 (In the formula, R¹ and R² are each a hydrogen or an alkyl group whose carbon number is 1 to 3, R³ is a hydrogen or an alkyl group whose carbon number is 1 to 20, R⁴ is a vinyl group or an alkyl group whose carbon number is 1 to 5, and n is a number from 0 to 3.)

other examples of the silane coupling agent having a functional group with metal capturing capability used in the present invention include γ-aminopropyltrimethoxysilane, γ-aminopropyltriethoxysilane, N-β(aminoethyl) γ-aminopropyltrimethoxysilane, N-β(aminoethyl) γ-aminopropyltriethoxysilane, and γ-mercaptopropyltrimethoxysilane.

Examples of the above-mentioned noble metal compound include chlorides, hydroxides, oxides, sulfates, and ammine complexes such as ammonium salts of palladium, silver, platinum, gold and so forth, which exhibit a catalytic action to deposit copper from an electroless plating solution onto the surface of the article to be plated. Palladium compounds are particularly favorable. Conventional catalysts such as tin chloride can also be contained within the scope of the present invention.

Using these methods to fix a catalyst further increases the plating uniformity.
When plating is performed using the electroless copper plating solution of the present invention, the material to be plated is immersed in the plating solution. The material being plated is preferably one that has pretreated as discussed above, so as to fix a catalyst.

### Examples

A silicon wafer on which a tantalum nitride film had been formed in a thickness of 15 nm by sputtering was plated as described in Examples 1 to 7 and Comparative Examples 1 to 3 below, and the appearance of the plating film after treatment was examined visually.

### Example 1

The above-mentioned silicon wafer with the tantalum nitride film was immersed for 5 minutes at 50°C in a pretreatment agent for plating prepared by adding a palladium chloride aqueous solution so as to be 50 mg/L to 0.16 wt% aqueous solution of the silane coupling agent that was the equimolar reaction product of imidazole and γ-glycidoxypropyltrimethoxysilane. After this, the wafer was heat treated for 15 minutes at 200°C, and then was electroless plated with copper for 5 minutes at 60°C. The composition of the plating solution was copper sulfate 0.04 mol/L, ethylenediaminetetraacetate 0.4 mol/L, formalin 0.1 mol/L, sodium hypophosphite 0.1 mol/L, and 2,2'-bipyridyl 10 mg/L, and the pH was 12.5 (pH regulator: sodium hydroxide). The plating film was formed uniformly without unevenness over the entire surface, and the film thickness was 50 nm.

### Example 2

The above-mentioned silicon wafer with the tantalum nitride film was pretreated by the same method as in Example 1, after which the wafer was electroless plated with copper for 5 minutes at 60°C. The composition of the plating solution was copper sulfate 0.04 mol/L, ethylenediaminetetraacetate 0.4 mol/L, glyoxylic acid 0.1 mol/L, hypophosphorous acid 0.1 mol/L, and 2,2'-bipyridyl 10 mg/L, and the pH was 12.5 (pH regulator: potassium hydroxide). The plating film was formed uniformly without unevenness over the entire surface, and the film thickness was 50 nm.

### Example 3

The above-mentioned silicon wafer with the tantalum nitride film was pretreated by the same method as in Example 1, after which the wafer was electroless plated with copper for 5 minutes at 60°C. The composition of the plating solution was copper sulfate 0.04 mol/L, ethylenediaminetetraacetate 0.4 mol/L, formalin 0.1 mol/L, ammonium hypophosphite 0.1 mol/L, and 2,2'-bipyridyl 10 mg/L, and the pH was 12.5 (pH regulator: sodium hydroxide). The plating film was formed uniformly without unevenness over the entire surface, and the film thickness was 50 nm.

### Example 4

The above-mentioned silicon wafer with the tantalum nitride film was pretreated by the same method as in Example 1, after which the wafer was electroless plated with copper for 5 minutes at 60°C. The composition of the plating solution was copper sulfate 0.04 mol/L, ethylenediaminetetraacetate 0.4 mol/L, glyoxylic acid 0.1 mol/L, potassium hypophosphite 0.1 mol/L, and 2,2'-bipyridyl 10 mg/L, and the pH was 12.5 (pH regulator: potassium hydroxide). The plating film was formed uniformly without unevenness over the entire surface, and the film thickness was 50 nm.

### Example 5

The above-mentioned silicon wafer with the tantalum nitride film was pretreated by the same method as in Example 1, after which the wafer was electroless plated with copper for 5 minutes at 60°C. The composition of the plating solution was copper sulfate 0.04 mol/L, ethylenediaminetetraacetate 0.4 mol/L, formalin 0.1 mol/L, sodium hypophosphite 0.1 mol/L, and thiourea 20 mg/L, and the pH was 12.5 (pH regulator: sodium hydroxide). The plating film was formed uniformly without unevenness over the entire surface, and the film thickness was 50 nm.

### Example 6

The above-mentioned silicon wafer with the tantalum nitride film was pretreated by the same method as in Example 1, after which the wafer was electroless plated with copper for 5 minutes at 60°C. The composition of the plating solution was copper sulfate 0.04 mol/L, ethylenediaminetetraacetate 0.4 mol/L, glyoxylic acid 0.1 mol/L, hypophosphorous acid 0.1 mol/L, and 2-mercaptobenzothiazole 15 mg/L, and the pH was 12.5 (pH regulator: potassium hydroxide). The plating film was formed uniformly without unevenness over the entire surface, and the film thickness was 50 nm.

### Example 7

The above-mentioned silicon wafer with the tantalum nitride film was pretreated by the same method as in Example 1, after which the wafer was electroless plated with copper for 5 minutes at 60°C. The composition of the plating solution was copper sulfate 0.04 mol/L, ethylenediaminetetraacetate 0.4 mol/L, formalin 0.1 mol/L, ammonium hypophosphite 0.1 mol/L, and thioglycolic acid 10 mg/L, and the pH was 12.5 (pH regulator: sodium hydroxide). The plating film was formed uniformly without unevenness over the entire surface, and the film thickness was 50 nm.

### Comparative Example 1

The above-mentioned silicon wafer with the tantalum nitride film was pretreated by the same method as in Example 1, after which the wafer was electroless plated with copper for 5 minutes at 60°C. The composition of the plating solution was copper sulfate 0.04 mol/L, ethylenediaminetetraacetate 0.4 mol/L, formalin 0.1 mol/L, and 2,2'-bipyridyl 10 mg/L, and the pH was 12.5 (pH regulator: sodium hydroxide). No plating film was deposited.

### Comparative Example 2

The above-mentioned silicon wafer with the tantalum nitride film was pretreated by the same method as in Example 1, after which the wafer was electroless plated with copper for 5 minutes at 80°C. The composition of the plating solution was copper sulfate 0.04 mol/L, ethylenediaminetetraacetate 0.4 mol/L, glyoxylic acid 0.1 mol/L, and 2,2'-bipyridyl 10 mg/L, and the pH was 12.5 (pH regulator: potassium hydroxide). The plating film was deposited in little islands and many portions without deposition were observed.

### Comparative Example 3

The above-mentioned silicon wafer with the tantalum nitride film was pretreated by the same method as in Example 1, after which the wafer was electroless plated with copper plating was performed for 10 minutes at 60°C. The composition of the plating solution was cupric chloride 0.04 mol/L, ethylenediaminetetraacetate 0.1 mol/L, formalin 0.1 mol/L, sodium hypophosphite 0.1 mol/L, amidosulfuric acid 0.3 mol/L, 4-aminobenzoic acid 200 mg/L, 2,2'-thiodiethanol 200 mg/L, and polyethylene glycol (Mw 20,000) 200 mg/L, and the pH was 12.5 (pH regulator: sodium hydroxide). The plating film was formed over the entire surface, but was very bumpy and non-uniform. The minimum film thickness was 800 nm.

As can be seen from the above description, when hypophosphorous acid or a hypophosphite is used as a second reducing agent along with a first reducing agent at the same time in an electroless copper plating solution, initial plating reactivity via a metal catalyst is higher than when the first reducing agent is used alone, and when a stabilizer to inhibit copper deposition is further used, excessive deposition reactions in some portion is prevented, and as a result, uniform plating at lower temperatures can be achieved even on a semiconductor wafer or other such mirror surface, on which a plating reaction hardly occurs.

## Claims

1. An electroless copper plating solution, wherein, along with a first reducing agent, hypophosphorous acid or a hypophosphite is used as a second reducing agent, and a stabilizer to inhibit copper deposition is further used at the same time.

2. An electroless copper plating solution according to Claim 1, which is used to produce a thin film with a thickness of 500 nm or less.

3. An electroless copper plating method, wherein an electroless copper plating solution according to Claim 1 or 2 is used to perform electroless copper plating on a mirror surface whose average surface roughness is less than 10 nm.
